(19) Europäisches Patentamt
European Patent Office
Office européen des brevets

(11) **EP 2 575 253 A1**

(12) **EUROPEAN PATENT APPLICATION**

(43) Date of publication:
**03.04.2013 Bulletin 2013/14**

(21) Application number: **12162033.0**

(22) Date of filing: **29.03.2012**

(51) Int Cl.:
**H03H 7/46** (2006.01)   **H03H 7/01** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.09.2011 JP 2011212677**

(71) Applicant: **Onkyo Corporation**
**Neyagawa-shi,**
**Osaka 572-8540 (JP)**

(72) Inventor: **Takahama, Koji**
**Osaka 572-8540 (JP)**

(74) Representative: **Horn Kleimann Waitzhofer**
**Elsenheimerstraße 65**
**DE-80687 München (DE)**

(54) **Branch ciruit**

(57)    In a branch circuit (100), a first band-pass filter (1) allows a first band signal in an input signal to pass therethrough.

A second band-pass filter (2) allows a second band signal in the input signal to pass therethrough. The first band-pass filter has a pre-resonance (11) circuit, a post-reso-nance (12) circuit, and a coil (13). The pre-resonance circuit has a coil (111), and a capacitor (112) connected to the coil in series and is connected to an input terminal (14) of the first band-pass filter. The post-resonance cir-cuit (12) has a coil (121), and a capacitor (122) connected to the coil in series, and is connected between the pre-resonance circuit and an output terminal (15) of the first band-pass filter. The coil (13) is connected between an output terminal (113) of the pre-resonance circuit and a ground.

FIG. 1

**Description**

BACKGROUND OF THE INVENTION

1. FIELD OF THE INVENTION

The present invention relates to a branch circuit, and more particularly to the branch circuit for separating a first band signal, and a second band signal different from the first band signal from an input signal.

2. DESCRIPTION OF THE RELATED ART

Branch circuits are circuits that separate signals in a plurality of frequency bands from an input signal. Use of the branch circuits enables a signal in a frequency band (174 to 240 MHz) of DAB (Digital Audio Broadcast) and a signal in a frequency band (76 to 108 MHz) of FM (Frequency Modulation) broadcasting to be separated from an input signal. The branch circuits have a band-pass filter for allowing signals in the frequency band of DAB to pass through, and a band-pass filter for allowing the signals in the frequency band of FM broadcasting to pass through. The band-pass filters are circuits for allowing signals in a desired band to pass through and attenuating signals other than ones in the desired band.

Conventionally, band-pass filters using an operational amplifier are known. Further, resonator-coupling type band-pass filters using a parallel resonance circuit having a coil and a capacitor connected to the coil in parallel are known. JP Patent publication 11-298202 describes a resonator-coupling type band-pass filter having two parallel resonance circuits. The band-pass filter in the Patent Document is formed so that the two parallel resonance circuits are connected to each other into π type.

One of characteristics of the resonator-coupling type band-pass filters is a steep frequency characteristic. Use of the resonator-coupling type band-pass filter enables a narrow-band signal to be separated from an input signal.

However, in the conventional resonator-coupling type band-pass filters, an input impedance in a pass band is higher than an input impedance in bands other than the pass band. In the resonator-coupling type band-pass filters, since the parallel resonance circuits are grounded, signals other than the pass band signal pass through the parallel resonance circuits so as to output to the ground. Therefore, when a first band signal and a second band signal are separated from an input signal, the use of the resonator-coupling type band-pass filters for passing of the first band signal causes an increase in loss of the second band signal.

SUMMARY OF THE INVENTION

It is an object of the present invention to provide a branch circuit that can suppress an increase in loss of signals in respective bands when signals in a plurality of bands are separated from an input signal.

A branch circuit of the present invention for separating a first band signal and a second band signal different from the first band signal from an input signal, comprises: a first band-pass filter for allowing the first band signal in the input signal to pass through; and a second band-pass filter for allowing the second band signal in the input signal to pass through. The first band-pass filter includes; a pre-resonance circuit having a first coil and a first capacitor connected to the first coil in series, the pre-resonance circuit being connected to an input terminal of the first band-pass filter, a post-resonance circuit having a second coil and a second capacitor connected to the second coil in series, and the post-resonance circuit being connected between the pre-resonance circuit and an output terminal of the first band-pass filter, and a third coil connected between the output terminal of the pre-resonance circuit and a ground.

According to the present invention, an input impedance of a first band-pass filter in a first band becomes lower than an input impedance in bands other than the first band. Since the second band signal is prevented from being output to the ground via the first band-pass filter, the loss of the second band signal can be prevented.

Preferably the first band-pass filter further includes a third capacitor connected between the third coil and the ground.

As a result, a cutoff characteristic of the first band-pass filter in the first band can be made to be steep.

Preferably when an impedance of the first band-pass filter is represented by $Z_L$, a center frequency of the first band-pass filter is represented by $f_0$, a bandwidth of the first band-pass filter is represented by $\Delta f$, and constants are represented by g1 and g2, an inductance $L_{s1}$ of the first coil and an inductance $L_{s2}$ of the second coil is expressed by the following (Formula 1), a capacitance $C_{s1}$ of the first capacitor and a capacitance $C_{s2}$ of the second capacitor are expressed by (Formula 2), and the inductance $L_c$ of the third coil is expressed by (Formula 3).

$$L_{s1} = L_{s2} = \left(1 - \frac{\Delta f}{f_0 \sqrt{g1 \cdot g2}}\right) \frac{Z_L \cdot g1}{2\pi\Delta f} \quad \cdots \quad \text{(Formula 1)}$$

$$C_{s1} = C_{s2} = \frac{2\pi\Delta f}{(2\pi f_0)^2 Z_L \cdot g1} \quad \cdots \quad \text{(Formula 2)}$$

$$L_c = \frac{Z_L \cdot g1}{2\pi f_0 \sqrt{g1 \cdot g2}} \quad \cdots \quad \text{(Formula 3)}$$

Use of the above (Formula 1), (Formula 2) and (Formula 3) enables parameters of respective elements composing the first band-pass filter to be determined.

BRIEF DESCRIPTION OF THE DRAWINGS

Fig. 1 a circuit diagram illustrating a branch circuit according to an embodiment of the present invention;
Fig. 2 is a circuit diagram illustrating a conventional low-pass filter;
Fig. 3 is a Bode diagram illustrating a frequency characteristic of a gain of a resonator-coupling type band-pass filter shown in Fig. 1;
Fig. 4 is a graph illustrating a frequency characteristic of an input impedance of the resonator-coupling type band-pass filter shown in Fig. 1;
Fig. 5 is a Bode diagram illustrating a frequency characteristic of a gain of the branch circuit shown in Fig. 1;
Fig. 6 is a graph illustrating a frequency characteristic of an input impedance of the branch circuit shown in Fig. 1;
Fig. 7 is a circuit diagram illustrating a conventional resonator-coupling type band-pass filter;
Fig. 8 is a Bode diagram illustrating a frequency characteristic of a gain of the resonator-coupling type band-pass filter shown in Fig. 7;
Fig. 9 is a graph illustrating a frequency characteristic of an input impedance of the resonator-coupling type band-pass filter shown in Fig. 7;
Fig. 10 is a circuit diagram illustrating a modified example of the resonator-coupling type band-pass filter shown in Fig. 1;
Fig. 11 is a Bode diagram illustrating a frequency characteristic of a gain of the band-pass filter shown in Fig. 10; and
Fig. 12 is a graph illustrating a frequency characteristic of an input impedance of the band-pass filter shown in Fig. 10.

DETAILED DESCRIPTION OF THE PREFERRED EMBODIMENT

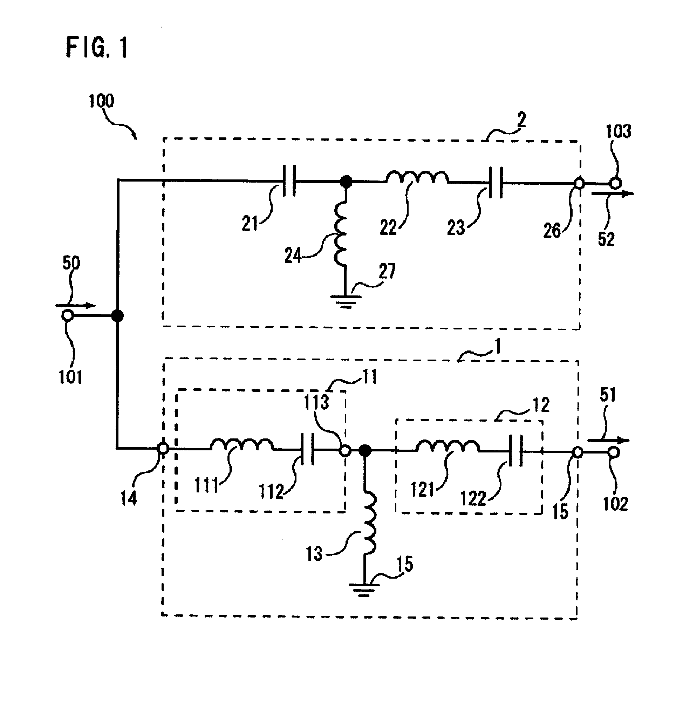

An embodiment of the present invention will be described in detail below with reference to the drawings. Like members are denoted by like reference symbols in the drawings, and description thereof is not repeated. {Constitution of Branch Circuit}
Fig. 1 is a circuit diagram illustrating a branch circuit 100 according to the embodiment. With reference to Fig. 1, the branch circuit 100 is provided with band-pass filters 1 and 2, an input terminal 101, output terminals 102 and 103. The band-pass filter 1 is connected between the input terminal 101 and the output terminal 102. The band-pass filter 2 is connected between the input terminal 101 and the output terminal 103.

EP 2 575 253 A1

The branch circuit 100 inputs an input signal 50 from the input terminal 101. The band-pass filter 1 allows a first band signal 51 in the input signal 50 to pass through. The first band signal 51 that passes through the band-pass filter 1 is output from the output terminal 102. The band-pass filter 2 allows a second band signal 52 in the input signal 50 to pass through. The second band signal 52 that passes through the band-pass filter 2 is output from the output terminal 103.

For example, the first band is a frequency band (174 to 240 MHz) of DAB. The second band is a frequency band (76 to 108 MHz) of FM broadcasting. The first band and the second band are not limited to these frequency bands. The second band may be a frequency band higher than the first band or lower than the first band.

A constitution of the band pass filter 1 will be described. The band-pass filter 1 is a resonator-coupling type band-pass filter. The band-pass filter 1 has a pre-resonance circuit 11, a post-resonance circuit 12, a coil 13, an input terminal 14, and an output terminal 15.

The pre-resonance circuit 11 is a series resonance circuit that has a coil 111, and a capacitor 112 connected to the coil 111 in series. The pre-resonance circuit 11 is connected to the input terminal 14. The pre-resonance circuit 11 further has the output terminal 113. One end of the coil 111 is connected to the input terminal 14, and the other end of the coil 111 is connected to the capacitor 112. The capacitor 112 is connected between the coil 111 and the output terminal 113.

The post-resonance circuit 12 is a series resonance circuit that has a coil 121, and a capacitor 122 connected to the coil 121 in series. The post-resonance circuit 12 is connected between the output terminal 15 of the pre-resonance circuit 11 and the output terminal 113 of the band-pass filter 1. One end of the coil 121 is connected to the output terminal 113, and the other end is connected to the capacitor 122. The capacitor 122 is connected between the coil 121 and the output terminal 15.

The coil 13 is connected between the output terminal 113 and a ground 15.

A constitution of the band-pass filter 2 will be described. The band-pass filter 2 has capacitors 21 and 23, coils 22 and 24, and an output terminal 26.

One end of the capacitor 21 is connected to the input terminal 101, and the other end of the capacitor 21 is connected to one end of the coil 22. The other end of the coil 22 is connected to one end of the capacitors 23. The other end of the capacitors 23 is connected to the output terminal 26. The coil 24 is connected between the other end of the capacitor 21 and a ground 27.

The constitution of the band-pass filter 2 is not limited to the above constitution.

{Characteristic of the Band-Pass Filter 1}

The band-pass filter 1 is a resonator-coupling type band-pass filter that has two series resonance circuits (the pre-resonance circuit 11 and the post-resonance circuit 12). In the band-pass filter 1, an input impedance in frequency bands other than the first band is higher than an input impedance in the first band.

For this reason, when the input impedance of the band-pass filter 2 in the second band is lower than the input impedance of the band-pass filter 1 in the second band, the second band signal 52 included in the input signal 50 is input into the band-pass filter 2. That is to say, the second band signal 52 can be prevented from passing through the pre-resonance circuit 11 and the coil 13 and being output to the ground 15. Therefore, the branch circuit 100 can prevent loss of the second band signal 52 and can separate the first band signal 51 and the second band signal 52 from the input signal 50.

{Relationship among Elements composing the Band-Pass Filter 1}

A relationship among the elements composing the band-pass filter 1 will be described. A resonance frequency of the pre-resonance circuit 11 matches with a resonance frequency of the post-resonance circuit 12. As a result, a frequency characteristic of a steep gain can be obtained.

Further, an inductance of the coil 111 matches with an inductance of the coil 121. In this case, a capacitance of the capacitor 112 matches with a capacitance of the capacitor 122. When not match, a center frequency of the resonance circuit composed of the pre-resonance circuit 11 and the coil 13 deviates from a center frequency of the resonance circuit composed of the post-resonance circuit 12 and the coil 13. As a result, since a bandwidth of the band-pass filter 1 is widened, the frequency characteristic of a steep gain cannot be obtained.

A method for calculating values of the respective elements composing the band-pass filter 1 will be described. In the calculation of the values of the elements, values of the elements of a normalization low-pass filter having the Butterworth characteristic are used.

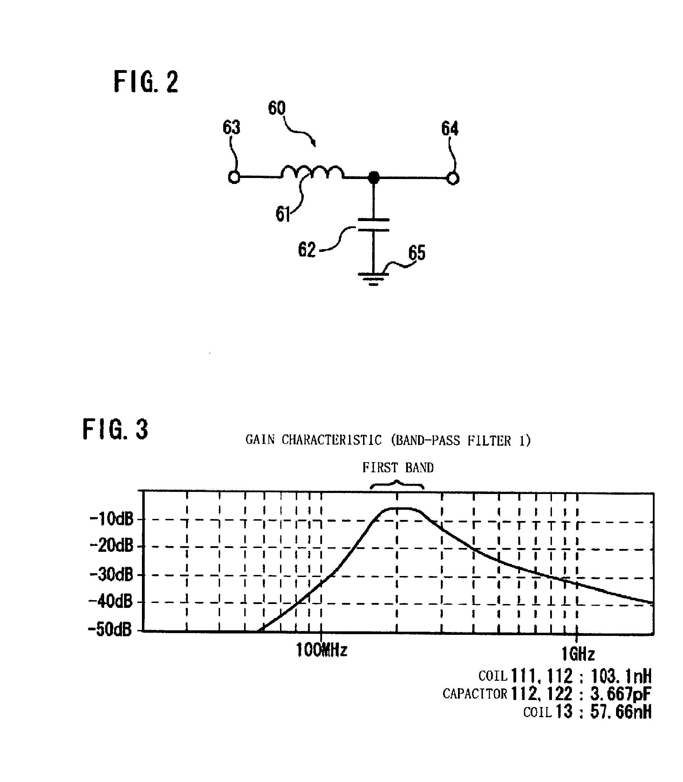

Fig. 2 is a circuit diagram illustrating a normalization low-pass filter 60. The normalization low-pass filter 60 has a coil 61, a capacitor 62, an input terminal 63, and an output terminal 64. One end of the coil 61 is connected to the input terminal 63, and the other end of the coil 61 is connected to the output terminal 64. The capacitor 62 is connected

4

between the other end of the coil 61 and a ground 65.

In the normalization low-pass filter 60, an impedance is 1 Ω. A cutoff frequency is $(1/2\pi)$ Hz. Therefore, an inductance of the coil 61 is 1.41421 H. A capacitance of the capacitor 62 is 1.41421 F.

The center frequency, the bandwidth, and the impedance of the band-pass filter 1 are represented by $f_0$, $\Delta f$, and $Z_L$. The values of the coils 13, 111 and 121, and the values of the capacitors 112 and 114 are calculated by using these parameters.

At first, constants g1 and g2 are defined based on the inductance of the coil 61 and the capacitance of the capacitor 62 as expressed by the following (Formula 4).

$$g1 = g2 = 1.41421 \quad \cdots \text{(Formula 4)}$$

The constants g1 and g2 match with the value of the coil 61 or the capacitor 62 of the normalization low-pass filter 60. A normalization coupling constant $k_{12}$ is defined by using the constants g1 and g2 according to the following (Formula 5).

$$k_{12} = \frac{1}{\sqrt{g1 \cdot g2}} \quad \cdots \text{(Formula 5)}$$

A constant $K_{12}$ is defined by using the normalization coupling constant $k_{12}$ according to the following (Formula 6).

$$K_{12} = \frac{\Delta f}{f_0 \sqrt{g1 \cdot g2}} \quad \cdots \text{(Formula 6)}$$

The constant $K_{12}$ is a numerical value such that the normalization coupling constant $k_{12}$ is changed according to the center frequency $f_0$ and the bandwidth $\Delta f$. The constant $K_{12}$ is a characteristic value of a coupled circuit where the pre-resonance circuit 11 is coupled with the post-resonance circuit 12. In this embodiment, the coupled circuit corresponds to the coil 13.

Provisional values (hereinafter, called provisional capacitances) of capacitances of the capacitors 112 and 122 are represented by $C_{t1}$. The provisional capacitances $C_{t1}$ may be any values. Provisional values of the inductances of the coils 111 and 121 (hereinafter, "provisional inductance") $L_{t1}$ are calculated by using the following (Formula 7). The provisional inductances $L_{t1}$ are calculated as the inductances of the coils resonating with the provisional capacitances $C_{t1}$.

$$L_{t1} = \frac{1}{(2\pi f_0)^2 \cdot C_{t1}} \quad \cdots \text{(Formula 7)}$$

A provisional value of the inductance of the coupled circuit (the coil 13) (hereinafter, "provisional coupled inductance") $L_{ct}$ is calculated according to the following (Formula 8).

$$L_{ct} = K_{12} \cdot L_{t1}$$
$$= \frac{\Delta f}{(2\pi f_0)^3 \cdot C_{t1} \sqrt{g1 \cdot g2}} \quad \cdots \text{(Formula 8)}$$

As expressed in the following (Formula 9), the inductance $L_{ct}$ of the coil 13 is subtracted from the provisional inductance $L_{t1}$ of the coils 111 and 121. The coupled circuit (the coil 13) as well as the coil 111 resonates with the capacitor 112. Further, the coupled circuit (the coil 13) as well as the coil 121 resonates with the capacitor 122. For this reason, when the coils 111 and 121 of the provisional inductances $L_{t1}$ are used directly, the center frequency of the band-pass filter 1 deviates from $f_0$. The provisional inductances $L_{t1}$ are adjusted by using the following (Formula 9) so that the deviation does not occur. As a result, the provisional inductances $L_{t2}$ of the coils 111 and 121 are calculated.

$$L_{t2} = L_{t1} - L_{ct}$$
$$= \left(1 - \frac{\Delta f}{f_0\sqrt{g1 \cdot g2}}\right)\frac{1}{(2\pi f_0)^2 C_{t1}} \quad \cdots \text{ (Formula 9)}$$

Next, Impedance conversion is made. The provisional capacitances $C_{t1}$, the provisional inductances $L_{t2}$, and the provisional coupled inductances $L_{ct}$ are changed according to the input impedance $R_L$ of the band-pass filter 1.
An input impedance Z1 and an output impedance Z2 of the band-pass filter 1 are calculated by using the following (Formula 10) and (Formula 11).

$$Z1 = \frac{\Delta f}{2\pi f_0^2 \cdot C_{t1} \cdot g1} \quad \cdots \text{ (Formula 10)}$$

$$Z2 = \frac{\Delta f}{2\pi f_0^2 \cdot C_{t1} \cdot g2} \quad \cdots \text{ (Formula 11)}$$

Since it is assumed that the normalization low-pass filter 60 has the Butterworth characteristic, the input impedance Z1 and the output impedance Z2 have the same value. Further, since the input impedance Z1 and the output impedance Z2 include the provisional capacitance $C_{t1}$, they correspond to a provisional value of the impedance of the band-pass filter 1.
A ratio R between the impedance $R_L$ of the band-pass filter 1 and the impedance Z1 is calculated by using the following (Formula 12).

$$R = Z_L/Z1 = \frac{Z_L(2\pi f_0)^2 C_{t1} \cdot g1}{2\pi \Delta f} \quad \cdots \text{ (Formula 12)}$$

As expressed in the following (Formula 13), the provisional inductance $L_{t2}$ is multiplied by the ratio R, so that an inductance $L_{s1}$ of the coil 111 and an inductances $L_{s2}$ of the coil 121 are obtained.

$$L_{s1} = L_{s2} = L_{T2}R$$
$$= \left(1 - \frac{\Delta f}{f_0\sqrt{g1 \cdot g2}}\right)\frac{Z_L \cdot g1}{2\pi \Delta f} \quad \cdots \text{ (Formula 13)}$$

As expressed in the following (Formula 14), the provisional capacitance $C_{t1}$ is multiplied by an inverse of the ratio R, so that a capacitance $C_{s1}$ of the capacitor 112 and a capacitance $C_{s2}$ of the capacitor 122 are obtained.

$$C_{s1} = C_{s2} = C_{t1} / R$$
$$= \frac{2\pi\Delta f}{(2\pi f_0)^2 Z_L \cdot g1} \quad \cdots \quad \text{(Formula 14)}$$

In the band-pass filter 1, the coupled circuit is composed of the coil 13. Therefore, an inductance $L_c$ of the coil 13 is calculated by multiplying the provisional coupled inductance $L_{ct}$ by the ratio R as expressed in the following (Formula 15).

$$L_c = L_{ct} \cdot R$$
$$= \frac{Z_L \cdot g1}{2\pi f_0 \sqrt{g1 \cdot g2}} \quad \cdots \quad \text{(Formula 15)}$$

As described above, g1 and g2 are constants. Therefore, it is found that the inductances $L_c$, $L_{s1}$ and $L_{s2}$ of the coils 13, 111 and 121, and the capacitances $C_{s1}$ and $C_{s2}$ of the capacitors 112 and 122 are determined by the impedance $R_L$, the center frequency $f_0$ and the bandwidth $\Delta f$ of the band-pass filter 1.

{Simulation of Frequency Characteristic}

The frequency characteristic of the band-pass filter 1 will be described below. Parameters of the band-pass filter 1 were set, and the frequency characteristic of the band-pass filter 1 was simulated.

Before the simulation, the center frequency $f_0$, the bandwidth $\Delta f$ and the impedance $Z_L$ of the band-pass filter 1 were set to 207 MHz, 105 MHz and 75 Ω. The inductances $L_{s1}$ and $L_{s2}$ of the coils 111 and 121 were set to 103.1 nH, and the capacitances $C_{s1}$ and $C_{s2}$ of the capacitors 112 and 122 were set to 3.667 pF. The inductance $L_c$ of the coil 13 was set to 57.66 nH.

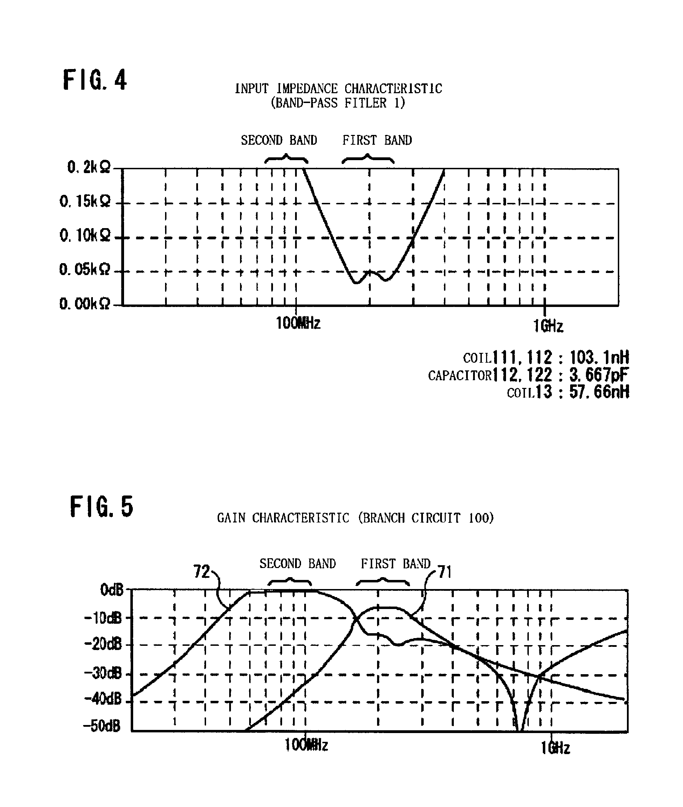

Fig. 3 is a Bode diagram illustrating a simulated result of the frequency characteristic (cutoff characteristic) of the gain in the band-pass filter 1. Fig. 4 is a graph illustrating a simulation result of the frequency characteristic of the input impedance in the band-pass filter 1.

With reference to Fig. 3, the gain of the band-pass filter 1 has a peak in the first band (174 to 240 MHz). With reference to Fig. 4, the input impedance of the band-pass filter 1 reduces from the center frequency $f_0$ (207 MHz). That is to say, the input impedance in the first band is lower than the input impedances in bands other than the first band.

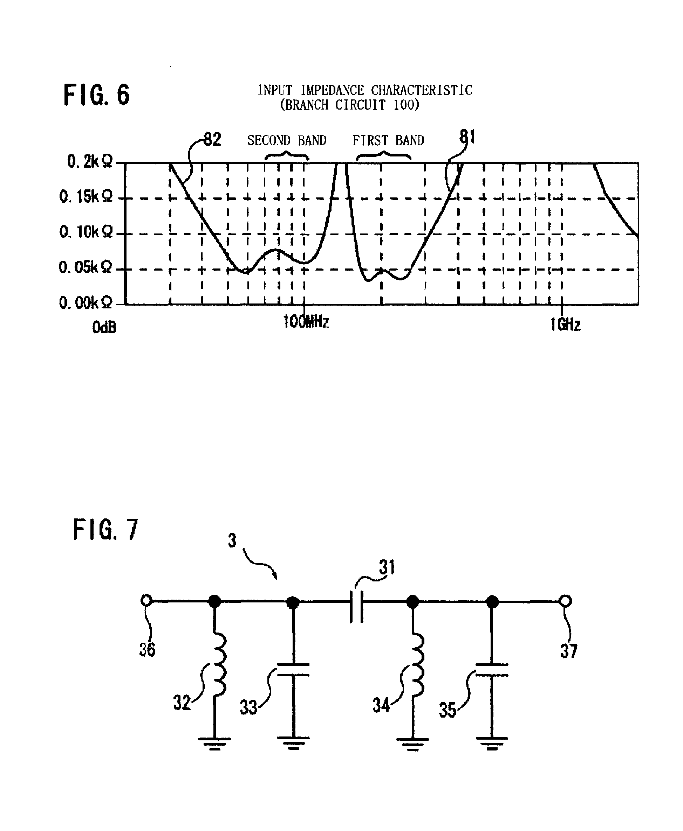

A frequency characteristic of the branch circuit 100 was simulated. Fig. 5 is a Bode diagram illustrating a simulated result of the frequency characteristic (cutoff characteristic) of the gain of the branch circuit 100. Fig. 6 is a graph illustrating a simulated result of a frequency characteristic of the input impedance of the branch circuit 100.

In the simulation of the branch circuit 100, the values of the respective elements of the band-pass filter 1 are the same as the values set at the time of the simulation of the band-pass filter 1. In the band-pass filter 2, the capacitance of the capacitor 21 was set to 18 pF, and the capacitance of the capacitors 23 was set to 5.6 pF. A reactance of the coil 22 was set to 560 mH, and a reactance of the coil 24 was set to 270 mH.

With reference to Fig. 5, a curved line 71 corresponds to the frequency characteristic of the gain of the band-pass filter 1, and a curved line 72 corresponds to the frequency characteristic of the gain of the band-pass filter 2. Since the peak is present in the first band and the second band, it is found that the branch circuit 100 can separate the first band signal 51 and the second band signal 52 from the input signal 50.

With reference to Fig. 6, a curved line 81 corresponds to the frequency characteristic of the input impedance of the band-pass filter 1. A curved line 82 corresponds to the frequency characteristic of the input impedance of the band-pass filter 2. In the first band, the input impedance of the band-pass filter 1 is lower than the input impedance of the band-pass filter 2. Therefore, the first band signal 51 is input into the band-pass filter 1. On the other hand, in the second band, the input impedance of the band-pass filter 2 is lower than the input impedance of the band-pass filter 1. Therefore, the second band signal 52 is input into the band-pass filter 2.

As a result, the second band signal 52 is prevented from being output to the ground 15 via the band-pass filter 1. Therefore, a loss of the second band signal 52 to be caused from the band-pass filter 1 can be prevented.

As a comparative example, a simulation result of a conventional resonator-coupling type band-pass filter will be described below. Fig. 7 is a circuit diagram illustrating the conventional resonator-coupling type band-pass filter. A band-pass filter 3 shown in Fig. 7 is provided with capacitors 31, 33 and 35, coils 32 and 34, an input terminal 36, and an output terminal 37.

One end of the capacitor 31 is connected to the input terminal 36, and the other end of the capacitor 31 is connected to the output terminal 37. One end of the coil 32 is connected to the input terminal 36, and the other end of the coil 32 is grounded. One end of the capacitor 33 is connected to the input terminal 36, and the other end of the capacitor 33 is grounded. That is to say, the capacitor 33 is connected to the coil 32 in parallel. One end of the coil 34 is connected to the other end of the capacitor 31, and the other end of the coil 34 is grounded. One end of the capacitor 35 is connected to the other end of the capacitor 31, and the other end of the capacitor 35 is grounded. That is to say, the capacitor 35 is connected to the coil 34 in parallel.

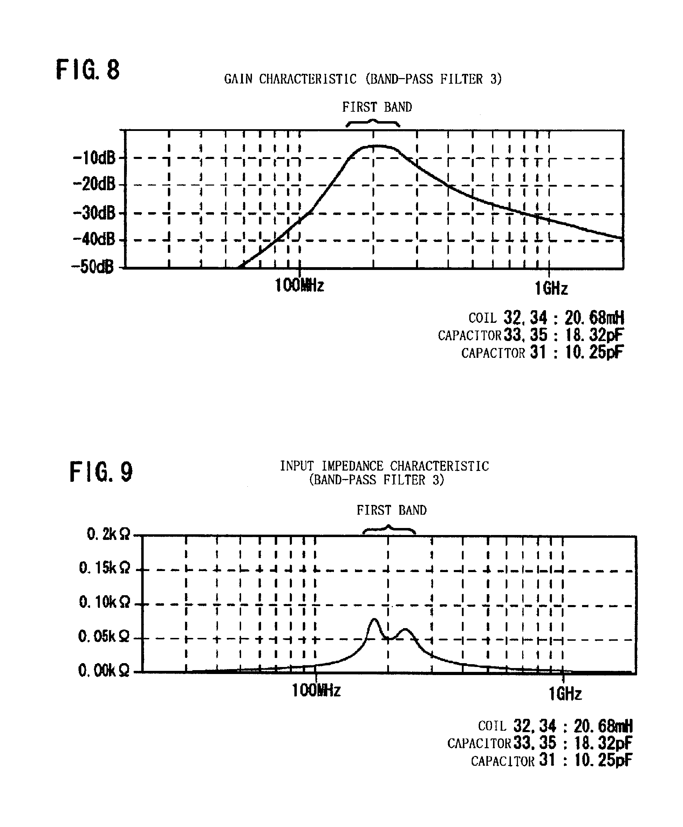

Fig. 8 is a Bode diagram illustrating a simulation result of a frequency characteristic (cutoff characteristic) of a gain of the band-pass filter 3. Fig. 9 is a graph illustrating a simulation result of a frequency characteristic of an input impedance of the band-pass filter 3. The center frequency $f_0$, the bandwidth $\Delta f$ and the impedance $Z_L$ of the band-pass filter 3 were set to the same values of the band-pass filter 1. A capacitance of the capacitor 31 was set to 10.25 pF, and capacitances of the capacitors 33 and 35 were set to 18.32 pF. Inductances of the coils 32 and 34 were set to 20.68 mH.

With reference to Fig. 3 and Fig. 8, the frequency characteristic of the gain of the band-pass filter 1 matches with the frequency characteristic of the gain of the band-pass filter 2.

With reference to Fig. 4 and Fig. 9, the frequency characteristic of the input impedance of the band-pass filter 3 is opposite to the frequency characteristic of the input impedance of the band-pass filter 1. That is to say, in the band-pass filter 3, the input impedance in the first band is higher than input impedances in bands other than the first band.

Therefore, in the branch circuit 100, when the band-pass filter 1 is replaced by the band-pass filter 3, the following problem arises. When the input impedance of the band-pass filter 2 in the second band is higher than the input impedance of the band-pass filter 3 in the second band, the second band signal is output to the ground via the band-pass filter 3. Since the second band signal is not input into the band-pass filter 2, a loss of the second band signal increases.

{Modified Example}

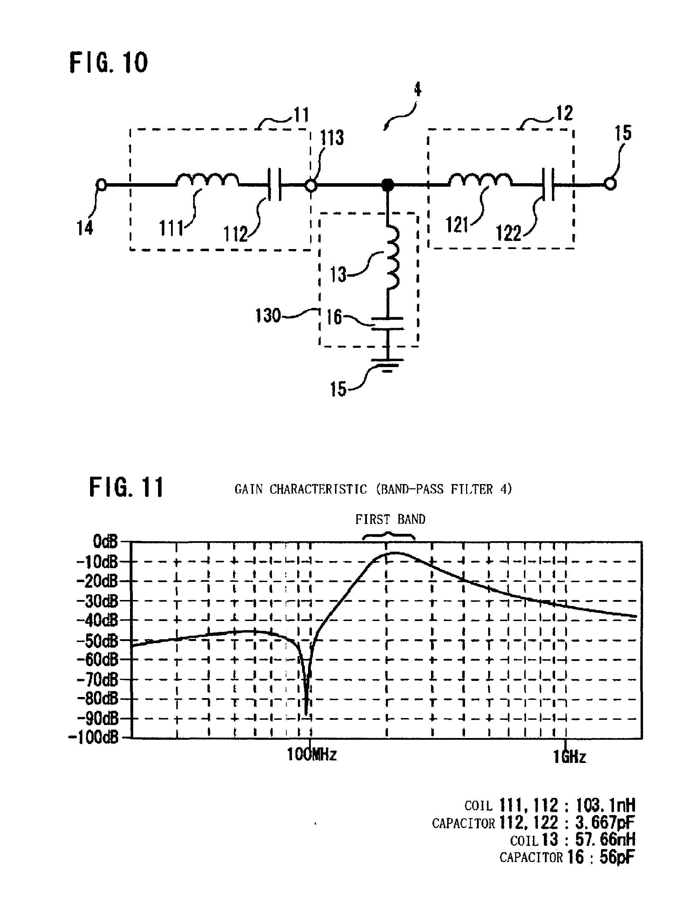

Fig. 10 is a circuit diagram illustrating a band-pass filter 4 that is a modified example of the band-pass filter 1. With reference to Fig. 10, in addition to the constitution of the band-pass filter 1, the band-pass filter 4 is provided with a capacitor 16. The capacitor 16 is connected between the coil 13 and the ground 15. The coil 13 and the capacitor 16 compose a series resonance circuit 130.

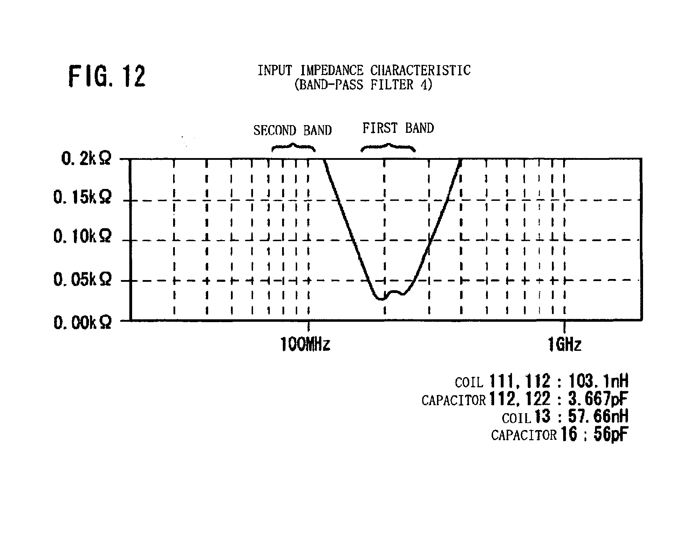

Fig. 11 is a Bode diagram illustrating a simulation result of a frequency characteristic (cutoff characteristic) of a gain of the band-pass filter 4. Fig. 12 is a graph illustrating a frequency characteristic of an input impedance of the band-pass filter 4. The values of the respective elements of the band-pass filter 1 are the same as the values set at the time of the simulation of the band-pass filter 1. A capacitance of the capacitor 16 is set to 56 pF.

With reference to Fig. 11, attenuation in the second band noticeably increases. This is because a resonant frequency of the series resonance circuit 130 (about 92 MHz) is included in the second band. That is to say, the series resonance circuit 130 functions as a notch filter. When the resonant frequency of the series resonance circuit 130 is represented by $f_n$, the inductance of the coil 13 is represented by $L_{13}$, and the capacitance of the capacitor 16 is represented by $C_{16}$, the resonant frequency $f_n$ is expressed by the following (Formula 16).

$$f_n = \frac{1}{2\pi\sqrt{L_{13} \cdot C_{16}}} \cdots \quad \text{(Formula 16)}$$

With reference to Fig. 3 and Fig. 11, the frequency characteristic of the gain of the band-pass filter 4 is steeper than the frequency characteristic of the gain of the band-pass filter 1.

With reference to Fig. 4 and Fig. 12, there is no great difference between the frequency characteristic of the input impedance of the band-pass filter 1 and the frequency characteristic of the input impedance of the band-pass filter 4. Therefore, also in the branch circuit 100, even when the band-pass filter 1 is replaced by the band-pass filter 4, the loss of the second band signal due to the band-pass filter 4 can be prevented, and the first band signal 51 and the second band signal 52 can be separated from the input signal 50.

The above described the embodiment of the present invention, but the above embodiment is only example for carrying out the present invention. Therefore, the present invention is not limited to the above embodiment, and can be carried out by suitably modifying the above embodiment within the scope that does not deviate from the gist.

**Claims**

1. A branch circuit for separating a first band signal and a second band signal different from the first band signal from an input signal, comprising:

    a first band-pass filter for allowing the first band signal in the input signal to pass through; and
    a second band-pass filter for allowing the second band signal in the input signal to pass through,
    wherein the first band-pass filter includes;
    a pre-resonance circuit having a first coil and a first capacitor connected to the first coil in series, the pre-resonance circuit being connected to an input terminal of the first band-pass filter,
    a post-resonance circuit having a second coil and a second capacitor connected to the second coil in series, and the post-resonance circuit being connected between the pre-resonance circuit and an output terminal of the first band-pass filter, and
    a third coil connected between the output terminal of the pre-resonance circuit and a ground.

2. The branch circuit according to claim 1, wherein the first band-pass filter further includes a third capacitor connected between the third coil and the ground.

3. The branch circuit according to claim 1 or 2, wherein
    when an impedance of the first band-pass filter is represented by $Z_L$, a center frequency of the first band-pass filter is represented by $f_0$, a bandwidth of the first band-pass filter is represented by $\Delta f$, and constants are represented by g1 and g2, an inductance $L_{s1}$ of the first coil and an inductance $L_{s2}$ of the second coil is expressed by the following (Formula 1),
    a capacitance $C_{s1}$ of the first capacitor and a capacitance $C_{s2}$ of the second capacitor are expressed by (Formula 2), and
    the inductance $L_c$ of the third coil is expressed by (Formula 3).

$$L_{s1} = L_{s2} = \left(1 - \frac{\Delta f}{f_0\sqrt{g1 \cdot g2}}\right)\frac{Z_L \cdot g1}{2\pi\Delta f} \quad \cdots \quad (\text{Formula 1})$$

$$C_{s1} = C_{s2} = \frac{2\pi\Delta f}{(2\pi f_0)^2 Z_L \cdot g1} \quad \cdots \quad (\text{Formula 2})$$

$$L_c = \frac{Z_L \cdot g1}{2\pi f_0 \sqrt{g1 \cdot g2}} \quad \cdots \quad (\text{Formula 3})$$

FIG. 1

## FIG. 2

## FIG. 3

GAIN CHARACTERISTIC (BAND-PASS FILTER 1)

FIRST BAND

COIL 111, 112 : 103. 1nH
CAPACITOR 112, 122 : 3. 667pF
COIL 13 : 57. 66nH

# FIG. 4

INPUT IMPEDANCE CHARACTERISTIC
(BAND-PASS FITLER 1)

SECOND BAND    FIRST BAND

0. 2kΩ
0. 15kΩ
0. 10kΩ
0. 05kΩ
0. 00kΩ

100MHz                                    1GHz

COIL111, 112 : 103. 1nH
CAPACITOR112, 122 : 3. 667pF
COIL13 : 57. 66nH

# FIG. 5

GAIN CHARACTERISTIC (BRANCH CIRCUIT 100)

72          SECOND BAND    FIRST BAND  71

0dB
-10dB
-20dB
-30dB
-40dB
-50dB

100MHz                                    1GHz

**FIG. 6**

INPUT IMPEDANCE CHARACTERISTIC
(BRANCH CIRCUIT 100)

**FIG. 7**

FIG. 8

GAIN CHARACTERISTIC (BAND-PASS FILTER 3)

FIRST BAND

COIL 32, 34 : 20. 68mH
CAPACITOR 33, 35 : 18. 32pF
CAPACITOR 31 : 10. 25pF

FIG. 9

INPUT IMPEDANCE CHARACTERISTIC
(BAND-PASS FILTER 3)

FIRST BAND

COIL 32, 34 : 20. 68mH
CAPACITOR 33, 35 : 18. 32pF
CAPACITOR 31 : 10. 25pF

14

## FIG. 10

## FIG. 11

GAIN CHARACTERISTIC (BAND-PASS FILTER 4)

FIRST BAND

COIL 111, 112 : 103.1nH
CAPACITOR 112, 122 : 3.667pF
COIL 13 : 57.66nH
CAPACITOR 16 : 56pF

FIG. 12

INPUT IMPEDANCE CHARACTERISTIC
(BAND-PASS FILTER 4)

COIL 111, 112 : 103. 1nH
CAPACITOR 112, 122 : 3. 667pF
COIL 13 : 57. 66nH
CAPACITOR 16 : 56pF

Europäisches
Patentamt
European
Patent Office
Office européen
des brevets

# EUROPEAN SEARCH REPORT

Application Number

EP 12 16 2033

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 03 823 B (DEUTSCHE BUNDESPOST) 7 March 1957 (1957-03-07) * column 3, lines 3 -7; figure 1 * ----- | 1,2 | INV. H03H7/46 H03H7/01 |
| X | DE 10 84 783 B (SIEMENS AG) 7 July 1960 (1960-07-07) * column 1, lines 45 -52; figure 1 * ----- | 1-3 | |
| X | US 2 358 520 A (LANDON VERNON D) 19 September 1944 (1944-09-19) * page 1, right-hand column, lines 23 -48; figure 2 * ----- | 1-3 | |
| A | EP 0 921 642 A2 (HITACHI METALS LTD [JP]) 9 June 1999 (1999-06-09) * paragraph [0013]; figures 6-14 * ----- | 1-3 | |
| A | CHIU C T ET AL: "Bandpass Filters Design in the Organic Substrate without Using Large-Value Capacitors", MICROSYSTEMS, PACKAGING, ASSEMBLY CONFERENCE TAIWAN, 2006 INTERNATIONA L, IEEE, PI, 1 October 2006 (2006-10-01), pages 1-4, XP031049544, ISBN: 978-1-4244-0734-7 * figure 1 * ----- | 1-3 | TECHNICAL FIELDS SEARCHED (IPC)  H03H |
| A | US 2 762 018 A (PURINGTON ELLISON S) 4 September 1956 (1956-09-04) * figure 6 * ----- | 1-3 | |
| A | JP 61 013706 A (MATSUSHITA ELECTRIC IND CO LTD) 22 January 1986 (1986-01-22) * abstract; figures 1-4 * ----- | 1-3 | |

The present search report has been drawn up for all claims

| Place of search | Date of completion of the search | Examiner |
|---|---|---|
| Munich | 16 July 2012 | Maget, Judith |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

**ANNEX TO THE EUROPEAN SEARCH REPORT
ON EUROPEAN PATENT APPLICATION NO.**                    EP 12 16 2033

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2012

| Patent document cited in search report | | Publication date | Patent family member(s) | | Publication date |
|---|---|---|---|---|---|
| DE 1003823 | B | 07-03-1957 | NONE | | |
| DE 1084783 | B | 07-07-1960 | NONE | | |
| US 2358520 | A | 19-09-1944 | NONE | | |
| EP 0921642 | A2 | 09-06-1999 | DE | 69827912 D1 | 05-01-2005 |
| | | | DE | 69827912 T2 | 04-08-2005 |
| | | | DE | 69831360 D1 | 29-09-2005 |
| | | | DE | 69831360 T2 | 29-06-2006 |
| | | | DE | 69835378 T2 | 08-03-2007 |
| | | | DE | 69835468 T2 | 15-03-2007 |
| | | | EP | 0921642 A2 | 09-06-1999 |
| | | | EP | 1315305 A1 | 28-05-2003 |
| | | | EP | 1418679 A1 | 12-05-2004 |
| | | | EP | 1443666 A2 | 04-08-2004 |
| | | | EP | 1473846 A2 | 03-11-2004 |
| | | | ES | 2232909 T3 | 01-06-2005 |
| | | | ES | 2244845 T3 | 16-12-2005 |
| | | | ES | 2268505 T3 | 16-03-2007 |
| | | | ES | 2270214 T3 | 01-04-2007 |
| | | | KR | 20040068522 A | 31-07-2004 |
| | | | KR | 20040094660 A | 10-11-2004 |
| US 2762018 | A | 04-09-1956 | NONE | | |
| JP 61013706 | A | 22-01-1986 | NONE | | |

EPO FORM P0459

For more details about this annex : see Official Journal of the European Patent Office, No. 12/82

**EP 2 575 253 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11298202 A